Europäisches Patentamt

European Patent Office

Office européen des brevets

(19)

(11) Numéro de publication : **0 567 356 B1**

## (12) FASCICULE DE BREVET EUROPEEN

(45) Date de publication du fascicule du brevet :
07.09.94 Bulletin 94/36

(51) Int. Cl.$^5$ : **G11C 16/06**

(21) Numéro de dépôt : **93400521.6**

(22) Date de dépôt : **02.03.93**

(54) **Dispositif et procédé d'effacement par secteurs d'une mémoire flash EPROM.**

(30) Priorité : **06.03.92 FR 9202700**

(43) Date de publication de la demande :
**27.10.93 Bulletin 93/43**

(45) Mention de la délivrance du brevet :
**07.09.94 Bulletin 94/36**

(84) Etats contractants désignés :
**DE FR GB IT**

(56) Documents cités :
**GB-A- 2 214 379
US-A- 4 949 309
1990 SYMPOSIUM ON VLSI CIRCUITS 9 Juin
1990, HONOLULU, HAWAI,US pages 101 - 102,
XP145626 NOZAKI ET AL. 'A 1 Mbit EEPROM
with MONOS memory cell for semiconductor
disk application'**

(73) Titulaire : **SGS-THOMSON
MICROELECTRONICS S.A.
7, Avenue Galliéni
F-94250 Gentilly (FR)**

(72) Inventeur : **Rouy, Olivier
Cabinet BALLOT-SCHMIT,
7, rue Le Sueur
F-75116 Paris (FR)**

(74) Mandataire : **Schmit, Christian Norbert Marie
et al
Cabinet Ballot-Schmit
7, rue Le Sueur
F-75116 Paris (FR)**

EP 0 567 356 B1

# Description

La présente invention concerne l'effacement d'un plan mémoire d'une flash EPROM découpé en secteurs.

Une mémoire flash EPROM est une mémoire qui se programme à la manière d'une mémoire EPROM par injection de porteurs chauds et qui s'efface à la manière d'une mémoire EEPROM, à cette différence que l'effacement porte sur la mémoire flash EPROM toute entière.

Pour permettre aux utilisateurs de partitionner leur plan mémoire applicatif selon la nature des informations à mémoriser, et en particulier selon la fréquence de rafraîchissement de ces informations, on a proposé une segmentation du plan mémoire d'une flash EPROM en plusieurs secteurs, qui permette d'effacer soit un, soit plusieurs, soit tous les secteurs de la mémoire en même temps.

Les secteurs ne sont pas forcément de même taille. Dans des applications habituelles, on propose un secteur de 0.2 Mbits et un autre de 0.8 Mbits pour une flash EPROM de 1 Mbits.

On rappelle qu'une cellule mémoire flash EPROM est constituée d'un transistor à grille flottante dont l'oxyde de grille est d'épaisseur faible et uniforme sur toute la longueur du canal de conduction. La faible épaisseur est de l'ordre de cent angströms ($100 \times 10^{-10}$m).

L'effacement du plan mémoire flash EPROM est effectué de manière connue en appliquant une tension d'effacement de l'ordre de neuf volts sur la source des cellules mémoires et en portant leurs grilles à la masse, les drains étant non connectés. La jonction source/substrat des cellules est alors polarisée en inverse. Le fort champ électrique à travers l'oxyde de grille déclenche la conduction par effet tunnel au niveau de la source. Le choix de la tension d'effacement de neuf volts correspond au point de fonctionnement optimum pour la source des cellules pour obtenir l'effacement par effet tunnel sans risquer de provoquer des courants de fuite dans la jonction source/substrat et sans risquer de faire passer en avalanche cette jonction.

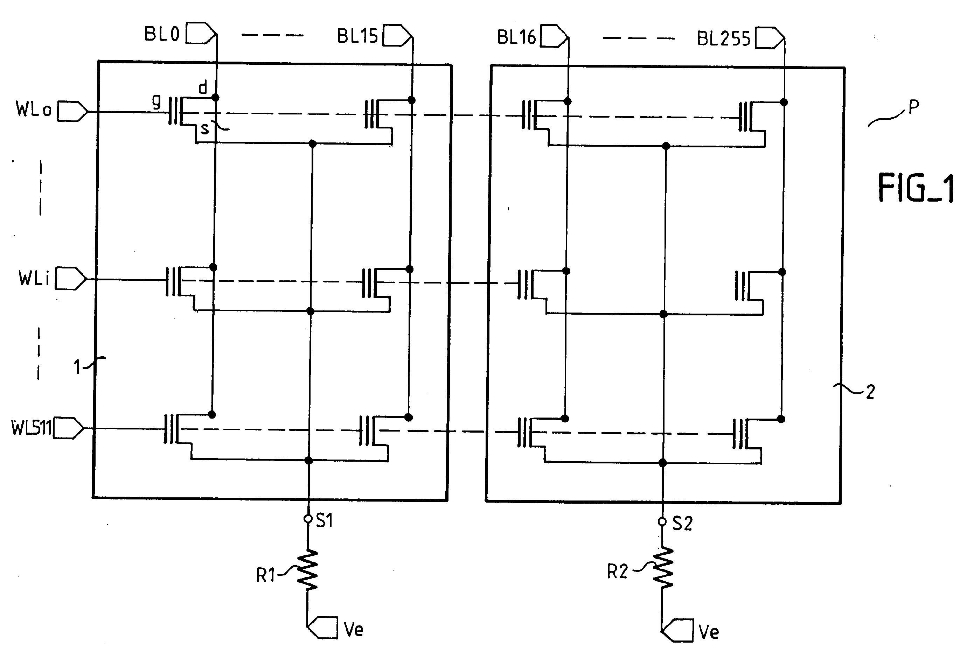

La segmentation du plan mémoire en vue de l'effacement par secteurs consiste alors à ce que les cellules d'un secteur aient leurs sources en commun. La figure 1 représente un tel plan mémoire (P) d'une flash EPROM découpé en deux secteurs.

Le plan mémoire (P) comporte dans cet exemple 256 lignes de bits (BLO à BL255) et 512 lignes de mots (WL0 à WL511).

A chaque intersection d'une ligne de bit et d'une ligne de mot, une cellule mémoire c a son drain d connecté à la ligne de bits et sa grille de commande g connectée à une ligne de mots.

Le premier secteur 1 recouvre les 16 premières lignes de bits BL0 à BL15 et les 512 lignes de mots WL0 à WL511. Toutes les cellules de ce premier secteur 1 ont leur source reliée à un premier noeud électrique S1.

Le deuxième secteur 2 recouvre les 240 dernières lignes de bits BL16 à BL255 et les 512 lignes de mots WL0 à WL511. Toutes les cellules de ce deuxième secteur 2 ont leur source reliée à un deuxième noeud électrique S2.

Dans cet exemple on a segmenté le plan mémoire selon les lignes de bit. On peut tout aussi bien les segmenter selon les lignes de mot, ou faire un mélange des deux types de segmentation.

Un secteur se définit simplement comme un ensemble de cellules mémoire ayant leurs sources reliées ensemble à un même noeud électrique.

L'effacement sélectif consiste alors à appliquer la tension d'effacement au noeud du secteur que l'on veut effacer. Cette tension d'effacement est appliquée au noeud d'un secteur à travers une résistance de limitation du courant d'effacement comme représenté sur la figure 1 : R1 pour le secteur 1, R2 pour le secteur 2. La valeur de la résistance de limitation d'un secteur donné est déterminée à partir du nombre de cellules de ce secteur et du courant d'effacement caractéristique attendu leff d'une cellule mémoire (connu pour un procédé technologique de fabrication donné), en sorte que la tension appliquée à la source commune du secteur, par exemple S1 pour le secteur 1, à travers cette résistance de limitation soit d'environ 9 volts. Le point de fonctionnement de la source des cellules est alors optimum pour l'effacement et pour la jonction source/substrat.

La formule de détermination de la résistance de limitation est donc la suivante :

$$Ve \ - \ R.n.Ieff \ = \ 9 \text{ volts}$$

Où n est le nombre de cellules du secteur, R la résistance de limitation du secteur et leff le courant d'effacement attendu pour une cellule.

On a donc en théorie la même tension de source en effacement pour chacun des secteurs.

Mais en pratique, la tension de source peut varier d'un secteur à l'autre. En effet le courant d'effacement du secteur peut être supérieur à celui attendu, à cause de courants de fuite dans des cellules par exemple. La tension de source sera alors inférieure à celle attendue, puisque la chute de tension dans la résistance sera plus importante.

En pratique, la tension de source d'un secteur en effacement sera de 9,2 volts et celle d'un autre secteur sera de 8,3 volts, à cause de ces courants de fuite.

Le champ électrique appliqué à l'oxyde de grille sera alors plus élevé pour les cellules du premier secteur qui va donc s'effacer plus vite que le deuxième.

Or, si on veut effacer les deux secteurs en même temps, on va appliquer la tension d'effacement Ve aux deux secteurs pendant une durée déterminée, puis on va lire les cellules pour vérifier si elles sont effacées ou non. Si elles ne le sont pas, on va réappliquer la tension d'effacement et ainsi de suite. Si le premier secteur s'efface plus rapidement que le deuxième, tant que ce dernier ne sera pas effacé, on continuera à appliquer la tension d'effacement aux deux secteurs. Les cellules du premier secteur vont alors se dépléter et le premier secteur sera altéré.

Ce problème de déséquilibre de vitesses d'effacement est un inconvénient majeur en pratique, car il conduit à des altérations des mémoires flash EPROM découpées en secteur sans que l'on puisse les maîtriser.

Ce déséquilibre empêche en pratique d'utiliser l'effacement parallèle des secteurs et pour effacer plusieurs ou tous les secteurs du plan mémoire, il faut alors les effacer les uns après les autres, ce qui est très long.

Dans l'invention, on résout le problème des déséquilibres entre les vitesses d'effacement pour permettre d'effacer soit tous les secteurs, soit plusieurs secteurs en parallèle de manière fiable, sans altération de la mémoire. L'invention permet également d'effacer les secteurs individuellement.

Dans l'invention, lorsque plusieurs secteurs doivent être effacés en parallèle, on leur impose un même chemin résistif. La tension réelle appliquée aux sources des cellules de ces secteurs sera donc la même pour toutes. Si un secteur a un courant d'effacement plus petit ou plus grand que celui attendu, la vitesse d'effacement sera plus rapide ou plus lente, mais elle sera la même pour tous les secteurs, puisque la tension d'effacement est appliquée aux secteurs à travers une même valeur de résistance.

Ainsi l'invention propose un dispositif d'effacement de secteurs d'un plan mémoire d'une flash EPROM, l'effacement de secteurs étant effectué au moyen d'une tension d'effacement appliquée aux sources communes des cellules mémoires de ces secteurs, comprenant des éléments résistifs par lesquels la tension d'effacement est appliquée, caractérisé en ce qu'il comporte des moyens d'aiguillage pour affecter un élément résistif prédéterminé à plusieurs secteurs lorsque ces secteurs sont sélectionnés en même temps pour être effacés.

Avantageusement, les moyens d'aiguillage permettent d'affecter un élément résistif propre à chaque secteur lorsque les secteurs sont sélectionnés individuellement pour être effacés.

L'invention a aussi pour objet une mémoire comportant un tel dispositif d'effacement et le procédé d'effacement correspondant, selon les revendications 6 et 8.

D'autres caractéristiques ou avantages de l'invention sont donnés dans la description qui suit à titre indicatif et non limitatif et en référence aux dessins annexés dans lesquels :

- la figure 1 représente un dispositif d'effacement d'un plan mémoire flash EPROM découpé en deux secteurs, déjà décrite;
- la figure 2 représente un dispositif d'effacement selon l'invention appliqué au plan mémoire de la figure 1.

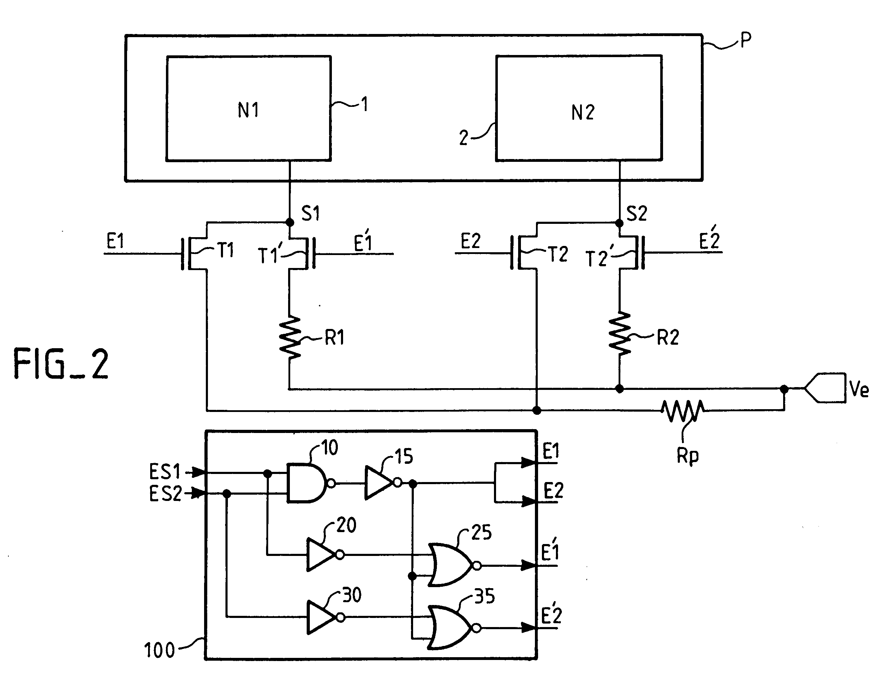

Pour la clarté de l'exposé, le plan mémoire représenté sur les figures 1 et 2 est découpé en deux secteurs.

La figure 2 représente un dispositif d'effacement permettant l'effacement des deux secteurs du plan mémoire en parallèle. Il permet aussi leur effacement individuel.

Le premier secteur 1 comporte N1 cellules mémoire dont les sources sont reliées ensemble au noeud électrique S1 (figure 1).

Le deuxième secteur 2 comporte N2 cellules mémoire dont les sources sont reliées ensemble au noeud électrique S2.

Un transistor de sélection parallèle T1, T2 est placé en série avec une résistance d'effacement parallèle Rp entre le noeud électrique S1, S2 de chaque secteur 1, 2 et la source de tension d'effacement. La résistance d'effacement parallèle Rp est commune à tous les secteurs du plan mémoire.

Entre le noeud électrique S1, S2 de chaque secteur 1,2 et la source de tension d'effacement Ve, un transistor de sélection individuelle T'1, T'2 et une résistance propre R1, R2 sont montés en série.

Les transistors de sélection parallèle T1, T2 sont commandés sur leurs grilles par des signaux de sélection parallèle E1, E2. Ils ont chacun une résistance équivalente négligeable devant la résistance d'effacement parallèle. De préférence, leur résistance équivalente est la même, c'est à dire qu'ils sont tous de même dimensions (géométrie).

Les transistors de sélection individuelle T'1, T'2 sont commandés sur leurs grilles par des signaux de sélection individuelle E'1, E'2. Ils ont chacun une résistance équivalente négligeable devant la résistance propre associée.

Ces signaux de sélection parallèle et individuelle sont délivrés par des moyens d'aiguillage 100 à partir de signaux d'effacement de secteurs ES1, ES2 délivrés par des moyens de décodage des instructions non représentés. Les moyens d'aiguillage 100 comportent dans l'exemple pris d'un plan découpé en deux secteurs :

- une porte NAND 10 recevant les signaux d'effacement de secteurs ES1 et ES2;
- un inverseur 15 en sortie de la porte 10 et qui délivre les signaux de sélection parallèle E1 et E2;
- un inverseur 20 du signal d'effacement du premier secteur ES1;
- une porte NOR 25 recevant les sorties des inverseurs 15 et 20 et délivrant le signal de sélection individuelle E'1 du premier secteur;
- un inverseur 30 du signal d'effacement du deuxième secteur ES2;

- une porte NOR 35 recevant les sorties des inverseurs 15 et 30 recevant les sorties des inverseurs 15 et 30 et délivrant le signal de sélection individuelle E'2 du deuxième secteur.

En prenant comme convention pour les signaux ES1 et ES2 un niveau actif pour sélectionner l'effacement du secteur, le fonctionnement logique est alors le suivant :

**Premier cas : ES1 = 1 et ES2 = 0**

La porte 10 délivre un 1 en sortie, et l'inverseur 15 délivre un 0. Les signaux de sélection parallèle E1 et E2 sont à zéro et les transistors de sélection parallèle T1 et T2 sont bloqués.

L'inverseur 20 délivre un 0 et la porte 25 délivre un 1 en sortie : le signal de sélection individuelle E'1 du premier secteur 1 est à 1 et le transistor associé T'1 est conducteur.

L'inverseur 30 délivre un 1 et la porte 35 délivre un 0 en sortie : le signal de sélection individuelle E'2 du deuxième secteur 2 est à 0 et le transistor associé T'2 est bloqué.

La tension d'effacement Ve est donc appliquée au seul premier secteur 1 à travers la résistance R1 et le transistor de sélection individuelle T'1.

**Deuxième cas : ES1 = 0 et ES2 = 1**

La porte 10 délivre un 1 en sortie et l'inverseur 15 délivre un 0. Les signaux de sélection parallèle E1 et E2 sont à zéro et les transistors associés T1 et T2 sont bloqués.

L'inverseur 20 délivre un 1 et la porte 25 délivre un 0 en sortie : le signal de sélection individuelle E'1 du premier secteur 1 est à 0 et le transistor associé T'1 est bloqué.

L'inverseur 30 délivre un 0 et la porte 35 délivre un 1 en sortie : le signal de sélection individuelle E'2 du deuxième secteur 2 est à 1 et le transistor associé T'2 est conducteur.

La tension d'effacement Ve est donc appliquée au seul deuxième secteur 2 à travers la résistance R2 et le transistor de sélection individuelle T'2.

**Troisième cas : ES1 = 1 et ES2 = 1**

La porte 10 délivre un 0 en sortie et l'inverseur 15 délivre un 1 : les signaux de sélection parallèle E1 et E2 sont à 1 et les transistors associés T1 et T2 sont conducteurs.

L'inverseur 20 délivre un 0 et la porte 25 délivre un 0 en sortie : le signal de sélection individuelle E'1 du premier secteur 1 est à zéro et le transistor associé T'1 est bloqué.

L'inverseur 30 délivre un 0 et la porte 35 délivre un 0 en sortie : le signal de sélection individuelle E'2 du deuxième secteur 2 est à 0 et le transistor associé T'2 est bloqué.

La tension d'effacement Ve est donc appliquée aux deux secteurs 1 et 2. Au premier, à travers la résistance Rp et le transistor de sélection parallèle T1 du premier secteur. Au deuxième, à travers la résistance Rp et le transistor de sélection parallèle T2 du deuxième secteur.

La résistance équivalente de chaque transistor de sélection parallèle T1 et T2 étant négligeable devant la résistance Rp, et de plus de valeur identique si ces deux transistors sont de même géométrie, la tension d'effacement Ve est appliquée à chacun des secteurs 1 et 2 à travers un même chemin résistif .

Les cellules de chacun des secteurs vont donc voir la même tension de source.

Si un courant d'effacement dans un des secteurs devait être en pratique plus petit ou plus grand que celui attendu, la vitesse d'effacement des secteurs sera plus rapide ou plus lente, mais elle restera la même pour les deux secteurs.

En pratique la résistance Rp est choisie en fonction du nombre de cellules du plan mémoire pour que la tension appliquée aux sources des cellules soit de neuf volts en effacement. De même, les résistances propres sont déterminées en fonction du nombre de cellules de leurs secteurs.

On peut étendre le principe d'effacement parallèle de secteurs de l'invention à n secteurs. Si on veut effacer plusieurs ou tous les secteurs en même temps, on va sélectionner un chemin résistif commun aux secteurs à effacer en même temps, de manière à assurer une même vitesse d'effacement pour tous ces secteurs.

Avantageusement, on efface individuellement un secteur parmi les n secteurs en sélectionnant un chemin résistif propre à ce secteur.

Les moyens d'aiguillage pour n secteurs comportent des portes logiques qui permettent d'assurer le fonctionnement logique suivant : lorsque plusieurs parmi n secteurs sont sélectionnés, leurs transistors de sélection parallèle sont rendus conducteurs et leurs transistors de sélection individuelle sont bloqués, pour appliquer la tension d'effacement à la source des secteurs à effacer à travers la résistance d'effacement parallèle Rp. Les transistors de sélection individuelle et parallèle des autres secteurs non sélectionnés sont bloqués.

Avantageusement, les moyens d'aiguillage pour n secteurs permettent également, lorsqu'un seul parmi n secteurs est sélectionné, de bloquer le transistor de sélection parallèle associé, et de rendre conducteur le transistor de sélection individuelle associé, pour appliquer la tension d'effacement à la source du secteur à travers sa résistance propre. Les transistors de sélection individuelle et parallèle des n-1 autres secteurs non sélectionnés sont bloqués.

L'invention permet d'obtenir un effacement optimum des secteurs du plan mémoire dans le cas d'effacements parallèles de plusieurs ou de tous les secteurs en même temps, sans altération de la mémoire. Elle permet aussi l'effacement sélectif d'un seul secteur.

## Revendications

1. Dispositif d'effacement de secteurs (1,2) d'un plan mémoire (P) d'une flash EPROM, l'effacement de secteurs étant effectué au moyen d'une tension d'effacement (Ve) appliquée aux sources communes des cellules mémoires (S1) de ces secteurs, comprenant des éléments résistifs (R1, Rp) par lesquels la tension d'effacement est appliquée, caractérisé en ce qu'il comporte des moyens d'aiguillage (100) pour affecter un élément résistif prédéterminé (Rp) à plusieurs secteurs lorsque ces secteurs sont sélectionnés en même temps pour être effacés.

2. Dispositif d'effacement de secteurs d'un plan mémoire d'une flash EPROM selon la revendication 1, caractérisé en ce que les moyens d'aiguillage permettent d'affecter un élément résistif propre (R1) à chaque secteur (1) lorsque les secteurs sont sélectionnés individuellement pour être effacés.

3. Dispositif d'effacement de secteurs d'un plan mémoire d'une flash EPROM selon les revendications 1 et 2, caractérisé en ce qu'il comporte des moyens de sélection comprenant pour chacun des secteurs, un premier transistor (T1) en série avec l'élément résistif prédéterminé (Rp), placés entre les sources communes des cellules mémoires (S1) du secteur (1) et la source de tension d'effacement (Ve) et un deuxième transistor (T'1) en série avec l'élément résistif propre (R1) au secteur (1), placés entre les sources communes des cellules mémoires (S1) du secteur (1) et une source de tension d'effacement (Ve).

4. Dispositif d'effacement d'un plan mémoire d'une flash EPROM selon la revendication 3, caractérisé en ce que les moyens d'aiguillage (100) comprennent des moyens (10, 15, 20, 25, 30, 35) pour rendre conducteur le premier transistor (T1) et non conducteur le deuxième transistor (T'1) des secteurs sélectionnés en même temps pour être effacés, de sorte que la tension d'effacement (Ve) soit appliquée par la résistance prédéterminée (Rp) et pour rendre non conducteur le premier transistor (T1) et conducteur le deuxième transistor (T'1) d'un secteur (1) sélectionné individuellement pour être effacé, de sorte que la tension d'effacement (Ve) soit appliquée par la résistance propre (R1) au secteur (1).

5. Dispositif d'effacement d'un plan mémoire d'une flash EPROM selon la revendication 4, caractérisé en ce que les moyens d'aiguillage comportent des portes logiques (10, 15, 20, 25, 30, 35).

6. Mémoire flash EPROM ayant un plan mémoire (P) découpé en secteurs (1, 2), comprenant des éléments résistifs (R1) pour appliquer une tension d'effacement (Ve) aux sources communes des cellules mémoires de secteurs sélectionnés pour être effacés, caractérisée en ce qu'elle comporte des moyens d'aiguillage (100) permettant d'affecter un élément résistif prédéterminé (Rp) à plusieurs secteurs sélectionnés en même temps pour être effacés, de manière à appliquer la tension d'effacement (Ve) à cet élément résistif.

7. Mémoire flash EPROM ayant un plan mémoire (P) découpé en secteurs (1, 2) selon la revendication 6, caractérisé en ce que les moyens d'aiguillage permettent d'affecter un élément résistif propre (R1) à chaque secteur sélectionné individuellement pour être effacé, de manière à appliquer la tension d'effacement (Ve) à la résistance propre de ce secteur.

8. Procédé d'effacement de secteurs (1,2) d'un plan mémoire (P) d'une flash EPROM, l'effacement de secteurs étant effectué au moyen d'une tension d'effacement (Ve) appliquée aux sources communes des cellules mémoires des secteurs, caractérisé en ce que lorsque plusieurs secteurs (1, 2) sont sélectionnés en même temps pour être effacés, la tension d'effacement (Ve) est appliquée aux sources communes des cellules mémoires de ces secteurs par un élément résistif prédéterminé (Rp) pour tous ces secteurs.

9. Procédé d'effacement de secteurs (1,2) d'un plan mémoire (P) d'une flash EPROM selon la revendication 8, caractérisé en ce que lorsqu'un secteur (1) est sélectionné individuellement pour être effacé, la tension d'effacement (Ve) est appliquée aux sources communes des cellules mémoires de ce secteur par un élément résistif propre (R1) à ce secteur (1).

10. Procédé d'effacement de secteurs d'un plan mémoire (P) d'une flash EPROM selon les revendications 8 et 9, caractérisé en ce que :
    - on sélectionne plusieurs secteurs au moyen d'un premier transistor (T1) que l'on rend conducteur pour appliquer la tension d'effacement (Ve) aux sources communes des cellules mémoires de ces secteurs par la résistance prédéterminée (Rp);
    - on sélectionne individuellement un secteur (1) au moyen d'un deuxième transistor (T'1) que l'on rend conducteur pour appliquer la tension d'effacement aux sources communes des cellules mémoires de ce secteur par la résistance propre (R1) au secteur.

## Patentansprüche

1. Vorrichtung zur Löschung von Sektoren (1,2) einer Speicherebene (P) eines Flash-EPROM, wobei die Löschung von Sektoren erfolgt mittels einer Löschspannung (Ve), angelegt an die zusammengeschlossenen Sources der Speicherzellen (S1) dieser Sektoren, resistive Elemente (R1, Rp) umfassend, durch die die Löschspannung angelegt wird,
   **dadurch gekennzeichnet,**
   daß sie Verzweigungseinrichtungen (100) umfaßt, um ein vorbestimmtes resistives Element (Rp) mehreren Sektoren zuzuordnen, wenn diese Sektoren gleichzeitig angesteuert werden, um gelöscht zu werden.

2. Vorrichtung zur Löschung von Sektoren einer Speicherebene eines Flash-EPROM nach Anspruch 1, dadurch gekennzeichnet, daß die Verzweigungseinrichtungen ermöglichen, jedem Sektor (1) ein eigenes resistives Element (R1) zuzuordnen, wenn diese Sektoren einzeln angesteuert werden, um gelöscht zu werden.

3. Vorrichtung zur Löschung von Sektoren einer Speicherebene eines Flash-EPROM nach den Ansprüchen 1 und 2, dadurch gekennzeichnet, daß sie Ansteuerungseinrichtungen enthält, umfassend, für jeden der Sektoren, einen ersten Transistor (T1), in Reihe mit dem vorher festgelegten resistiven Element (Rp), angeordnet zwischen den zusammengeschlossenen Sources der Speicherzellen (S1) des Sektors (1) und der Löschspannungsguelle (Ve), und einen zweiten Transistor (T'1), in Reihe mit dem eigenen resistiven Element (R1) des Sektors (1), angeordnet zwischen den zusammengeschlossenen Sources dieser Speicherzellen (S1) des Sektors (1) und einer Löschspannungsquelle (Ve).

4. Vorrichtung zur Löschung von Sektoren einer Speicherebene eines Flash-EPROM nach Anspruch 3, dadurch gekennzeichnet, daß die Verzweigungseinrichtungen (100) Einrichtungen umfassen (10, 15, 20, 25, 30, 35), um den ersten Transistor (T1) leitend zu machen und den zweiten Transistor (T'1) der gleichzeitig angesteuerten, zu löschenden Sektoren nichtleitend, so daß die Löschspannung (Ve) durch den vorher festgelegten Widerstand (Rp) angelegt wird, und um den ersten Transistor (T1) nichtleitend zu machen und den zweiten Transistor (T'1) eines einzeln angesteuerten, zu löschenden Sektors leitend, so daß die Löschspannung (Ve) durch den eigenen Widerstand (R1) an den Sektor (1) gelegt wird.

5. Vorrichtung zur Löschung von Sektoren einer Speicherebene eines Flash-EPROM nach Anspruch 4, dadurch gekennzeichnet, daß die Verzweigungseinrichtungen logische Glieder (10, 15, 20, 25, 30, 35) umfassen.

6. Flash-EPROM-Speicher mit einer in Sektoren (1, 2) aufgeteilten Speicherebene (P), resitive Elemente (R1) umfassend, um eine Löschspannung (Ve) an die zusammengeschlossenen Sources der Speicherzellen von Sektoren zu legen, angesteuert um gelöscht zu werden, dadurch gekennzeichnet, daß er Verzweigungseinrichtungen (100) umfaßt, die ermöglichen, ein vorher festgelegtes resistives Element (Rp) mehreren Sektoren zuzuordnen, gleichzeitig angesteuert um gelöscht zu werden, um die Löschspannung (Ve) an dieses resitive Element anzulegen.

7. Flash-EPROM-Speicher mit einer in Sektoren (1, 2) aufgeteilten Speicherebene (P) nach Anspruch 6, dadurch gekennzeichnet, daß die Verzweigungseinrichtungen ermöglichen, jedem einzeln zur Löschung angesteuerten Sektor ein eigenes resistives Element (R1) zuzuordnen, um die Löschspannung (Ve) an den eigenen Widerstand dieses Sektors zu legen.

8. Verfahren zur Löschung von Sektoren (1, 2) einer Speicherebene (P) eine Flash-EPROM, wobei die Löschung von Sektoren erfolgt mittels einer Löschspannung (Ve), angelegt an die zusammengeschlossenen Sources der Speicherzellen der Sektoren, dadurch gekennzeichnet, daß, wenn mehrere Sektoren (1, 2) gleichzeitig angesteuert werden um gelöscht zu werden, die Löschspannung (Ve) an die zusammengeschlossenen Sources dieser Speicherzellen angelegt wird durch ein vorher festgelegtes resistives Element (Rp) für alle diese Sektoren.

9. Verfahren zur Löschung von Sektoren (1, 2) einer Speicherebene (P) eines Flash-EPROM nach Anspruch 8, dadurch gekennzeichnet, daß, wenn ein Sektor (1) einzeln angesteuert wird um gelöscht zu werden, die Löschspannung (Ve) an die zusammengeschlossenen Sources der Speicherzellen dieses Sektors angelegt wird durch ein eigenes resistives Element (R1) dieses Sektors (1).

10. Verfahren zur Löschung von Sektoren einer Speicherebene (P) eines Flash-EPROM nach den Ansprüchen 8 und 9, dadurch gekennzeichnet, daß:

- man mehrere Sektoren ansteuert mittels eines ersten Transistors (T1), den man leitend macht, um die Löschspannung (Ve) an die zusammengeschlossenen Sources der Speicherzellen dieser Sektoren zu legen durch den vorher festgelegten Widerstand (Rp);
- man einzeln einen Sektor (1) mittels eines zweiten Transistors (T'1) ansteuert, den man leitend macht, um die Löschspannung an die zusammengeschlossenen Sources der Speicherzellen dieses Sektors zu legen durch den eigenen Widerstand (R1) des Sektors.

## Claims

1. Device for erasing sectors (1, 2) of a memory plane (P) of a flash EPROM, the erasure of sectors being effected by means of an erasure voltage (Ve) applied to the common sources of the memory cells (S1) in these sectors, comprising resistive elements (R1, Rp) by means of which the erasure voltage is applied, characterised in that it includes switching means (100) for allocating a predetermined resistive element (Rp) to several sectors when these sectors are selected at the same time for being erased.

2. Device for erasing sectors of a memory plane of a flash EPROM according to Claim 1, characterised in that the switching means enable a particular resistive element (R1) to be allocated to each sector (1) when the sectors are selected individually for being erased.

3. Device for erasing sectors of a memory plane of a flash EPROM according to Claims 1 and 2, characterised in that it includes selection means comprising, for each of the sectors, a first transistor (T1) in series with the predetermined resistive element (Rp), placed between the common sources of the memory cells (S1) of the sector (1) and the source of erasure voltage (Ve) and a second transistor (T'1) in series with the resistive element (R1) particular to the sector (1), placed between the common sources of the memory cells (S1) of the sector (1) and the source of erasure voltage (Ve).

4. Device for erasing a memory plane of a flash EPROM according to Claim 3, characterised in that the switching means (100) comprise means (10, 15, 20, 25, 30, 35) for making the first transistor (T1) conductive and the second transistor (T'1) non-conductive, for the sectors selected at the same time for being erased, so that the erasure voltage (Ve) is applied by the predetermined resistance (Rp) and for making the first transistor (T1) non-conductive and the second transistor (T'1) conductive for a sector (1) selected individually for being erased, so as the erasure voltage (Ve) is applied by the resistance (R1) particular to the sector (1).

5. Device for erasing a memory plane of a flash EPROM according to Claim 4, characterised in that the switching means include logic gates (10, 15, 20, 25, 30, 35).

6. Flash EPROM with a memory plane (P) divided into sectors (1, 2), comprising resistive elements (R1) for applying an erasure voltage (Ve) to the common sources of the memory cells of sectors selected for being erased, characterised in that it includes switching means (100) enabling a predetermined resistive element (Rp) to be allocated to several sectors selected at the same time for being erased, so as to apply the erasure voltage (Ve) to this resistive element.

7. Flash EPROM with a memory plane (P) divided into sectors (1, 2) according to Claim 6, characterised in that the switching means make it possible to allocate a particular resistive element (R1) to each sector selected individually for being erased, so as to apply the erasure voltage (Ve) at the particular resistance of this sector.

8. Method for erasing sectors (1, 2) of a memory plane (P) of a flash EPROM, the erasure of sectors being effected by means of an erasure voltage (Ve) applied to the common sources of the memory cells of the sectors, characterised in that, when several sectors (1, 2) are selected at the same time for being erased, the erasure voltage (Ve) is applied to the common sources of the memory cells of these sectors by a predetermined resistive element (Rp) for all these sectors.

9. Method of erasing sectors (1, 2) of a memory plane (P) of a flash EPROM according to Claim 8, characterised in that, when a sector (1) is selected individually for being erased, the erasure voltage (Ve) is applied to the common sources of the memory cells of this sector by a resistive element (R1) particular to this sector (1).

10. Method of erasing sectors of a memory plane (P) of a flash EPROM according to Claims 8 and 9, characterised in that:

- several sectors are selected by means of a first transistor (T1) , which is made conductive in order to apply the erasure voltage (Ve) to the common sources of the memory cells of these sectors through the predetermined resistance (Rp);

- a sector (1) is selected individually by means of a second transistor (T'1), which is made conductive in order to apply the erasure voltage to the common sources of the memory cells of this sector through the resistance (R1) particular to the sector.

FIG_1

EP 0 567 356 B1

FIG_2